# EUROPÄISCHE PATENTSCHRIFT

(11) **EP 0 272 372 B1**
(45) Veröffentlichungstag und Bekanntmachung des Hinweises auf die Patenterteilung: **11.01.1995**
(21) Anmeldenummer: 87109847.1
(22) Anmeldetag: 08.07.1987
(51) Int. Cl.: H01L 21/82, H01L 27/144, G02B 6/42, G02B 6/12, H01L 31/105, H01L 29/808, H01L 29/812

(54) **Verfahren zur Herstellung eines monolithisch integrierten Photoempfängers**
Method of making a monolithic integrated photodetector
Méthode de fabrication d'un photodétecteur intégré monolithique

(30) Priorität: 24.12.1986 DE 3644408
(43) Veröffentlichungstag der Anmeldung: 29.06.1988
(73) Patentinhaber: Licentia Patent-Verwaltungs-GmbH, 60596 Frankfurt (DE)
(72) Erfinder: Dämbkes, Heinrich, Dr.-Ing., D-7900 Ulm (DE); Haspeklo, Horst, Dr. rer. nat., D-7915 Elchingen (DE); König, Ulf, Dr.-Ing., D-7900 Ulm (DE)
(74) Vertreter: Weber, Gerhard, Dipl.-Phys.

(56) Entgegenhaltungen:
- EP-A- 0 133 709
- EP-A- 0 133 709
- CA-A- 980 451
- US-A- 4 136 928
- US-A- 4 136 928
- EDN ELECTRICAL DESIGN NEWS, Band 19, Nr. 10, 20. Mai 1974, Seiten 20-21,Denver, US; E. VODOVOZ: "Optical IC's: a coming technology"
- APPLIED PHYSICS LETTERS, Band 46, Nr. 5, 1. März 1985, Seiten 498-500, AmericanInstitute of Physics, Woodbury, US; R.W. WU et al.: "Optical waveguidedetection: Photodetector array formed on the waveguide utilizing laserrecrystallized silicon"

## Beschreibung

Die Erfindung betrifft ein Verfahren zur Herstellung eines monolithisch integrierten Photoempfängers nach dem Oberbegriff der Patentansprüche 1 und 3.

Die so hergestellten Photoempfänger sind für Meß- oder Nachrichtenübertragungssysteme geeignet. Vorbekannte Lösungen von monolithisch integrierten optoelektronischen Empfängerschaltungen sind beispielsweise eine Kombination einer PIN-Photodiode und eines JFET (Junction Field Effect Transistor) auf InGaAs Basis ( Lit.: R.E.Nahory, R.F.Leheny, Proc.Soc.Photo-Optical Instrum. Eng. 272, S.32-35, 1981) oder eine Kombination einer PIN-Photodiode und eines Heterobipolartransistor aus InP/TnGaAsP-Verbindungen. Die PIN-Photodioden sind jedoch lediglich für senkrecht zur Halbleiterschichtenfolge eingestrahltes Licht empfindlich und die Ankopplung eines optischen Wellenleiters kann nur hybrid erfolgen. Diese optischen Empfängerschaltungen haben den Nachteil, daß sie lange Schaltzeiten und hohe Rauschzahlen besitzen. Die hybride Ankopplung des Wellenleiters hat außerdem einen hohen optischen Leistungsverlust zur Folge.

In der kanadischen Patentanmeldung CA-A-980 451 ist ein monolithisch integrierter Photoempfänger beschrieben, der aus einer PIN-Photodiode und einem zugehörigen Verstärker (als Si-MOSFET ausgebildet) besteht, bei dem ein optischer Wellenleiter in einer Rille seitlich an die absorbierende Halbleiterschicht herangeführt ist. Ein entsprechendes Herstellungsverfahren ist auch beschrieben. Bei der aus der CA-A 980 451 bekannten Struktur ist die lichtführende Schicht kein Bestandteil der Photodiode.

Aus der europäischen Patentanmeldung EP-A-0 133 709 ist ein monolithisch integrierter Photoempfänger bekannt, der aus einer PIN-Photodiode und einem zugehörigen Verstärker (z.B. als HEMT ausgebildet) besteht und aus auf einem Substrat aufgewachsenen Heterostruktur-Halbleiterschichten aus III-V-Verbindungsmaterialien aufgebaut ist.

Außerdem ist aus der US-Patentschrift US-A-4 136 928 bekannt, einen optischen Wellenleiter durch monolithische Integration (bei Verwendung von Heterostruktur-Halbleiterverfahren) an eine PIN-Photodiode anzukoppeln. Da gelangen die Heterostruktur-Halbleiterschichten sowohl für den Wellenleiter als auch die PIN-Diode zur Anwendung.

In der europäischen Patentanmeldung EP-A-0 272 384 sind beispielhaft gewählte monolithisch integrierte Photoempfänger mit angekoppeltem optischen Wellenleiter beschrieben. Die lichtführende Halbleiterschicht des optischen Wellenleiters ist dabei Bestandteil der PIN-Phododiode. Bei einem derart strukturierten Photoempfänger ist die optische Signalverarbeitung abhängig vom Kopplungsfaktor zwischen lichtführender Halbleiterschicht und absorbierender Halbleiterschicht. Es ist daher eine Anpassung der lateralen Abmessungen und damit eine bestimmte Größe des Photoempfängers notwendig.

Der Erfindung liegt daher die Aufgabe zugrunde ein Verfahren zur Herstellung eines schnellschaltenden und rauscharmen, monolithisch integrierten Photoempfängers anzugeben, das bei einer zuverlässigen sowie kostengünstigen Herstellungsweise eine möglichst große Packungsdichte von elektronischen Bauelementen ermöglicht. Diese Aufgabe wird gelöst durch die im kennzeichnenden Teil der Patentansprüche 1 oder 3 angegebenen Merkmale. Vorteilhafte Ausgestaltungen und Weiterbildungen sind den Unteransprüchen entnehmbar.

Die monolithisch integrierte optische Empfängerschaltung ist für einen in der Lichtleitfasertechnik nützlichen Wellenlängenbereich λ von vorzugsweise 0,8 ≦ λ ≦ 1,55 µm geeignet.

Ein Vorteil der monolithischen Integration von Wellenleiter, optischem Empfänger und dazugehörigem Verstärker besteht darin, daß ein geringerer Leistungsverlust auftritt als bei einer hybriden Bauweise.

Außerdem ist das Herstellungsverfahren einer monolithisch integrierten Empfängerschaltung gemäß der Erfindung wesentlich einfacher und kostengünstiger als das einer hybriden Bauform. Weiterhin ist durch das direkte Einstrahlen des Lichtes in die absorbierende Halbleiterschicht der PIN-Photodiode die optische Signalverarbeitung unabhängig vom Kopplungsfaktor zwischen lichtführender Halbleiterschicht und absorbierender Halbleiterschicht. Dadurch sind kleinere Abmessungen des Photoempfängers möglich, sowohl in lateraler wie auch in vertikaler Richtung.

Die Erfindung wird im folgenden anhand von Ausführungsbeispielen unter Bezugnahme auf schematische Zeichnungen näher erläutert.

Die Figuren 1a, 1b, 1c zeigen die Verfahrensschritte zur Herstellung der selektiv gewachsenen Heterostruktur.

Fig. 2 bis 5 zeigen Längsschnitte von verschiedenen Ausführungsformen von PIN-HEMT-Photoempfängern mit angekoppel tem Wellenleiter.
PIN-HEMT-Photoempfänger ist eine Kurzbezeichnung für einen Photoempfänger bestehend aus einer PIN-Photodiode und einem HEMT (High Electron Mobility Transistor).

Die Erfindung beruht darauf, daß aus einer auf einem Substrat selektiv aufgewachsenen Heterostruktur ein Photoempfänger mit seitlich angekoppeltem optischen Wellenleiter hergestellt wird. Durch das selektive Wachstum kann der Wellenleiter optimal an den Photoempfänger angekoppelt werden. Die Abmessungen der PIN-Photodiode können dadurch unabhängig von der Koppellänge des einlaufenden Lichtes gewählt werden. Außerdem ist durch das selektive Wachstum der Halbleiterschichten eine vorteilhafte planare Bauform des Photoempfängers möglich. Um das Licht vollständig in der absorbierenden Halbleiterschicht der PIN-Photodiode auszukoppeln, muß lediglich der Brechungsindex der absorbierenden Halbleiterschicht größer sein als der der lichtführenden Halbleiterschicht. Der optische Empfänger ist vorteilhafterweise eine PIN-Photodiode mit hohem Quantenwirkungsgrad. Der dazugehörige Feldeffektransistor ist als HEMT ausgebildet, der für eine schnelle elektronische Signalverarbeitung geeignet ist. PIN-Photodiode und HEMT sind entweder in Mesabauweise oder planar angeordnet. Im Fall der optischen Signalverarbeitung, z.B. Multiplexen oder Demultiplexen, besteht die integrierte optische Empfängerschaltung aus mehreren PIN-Photodioden mit angekoppelten Wellenleitern. Außerdem schließt die Erfindung die monolithische Integration von mehreren HEMT zur Bildung eines Vorverstärkers mit ein. In den Ausführungsbeispielen werden jedoch aus Gründen der Übersichtlichkeit lediglich Kombinationen einer PIN-Photodiode mit angekoppeltem Wellenleiter und einem HEMT beschrieben.

Die Herstellung des erfindungsgemäßen Photoempfängers erfordert zwei Halbleiterwachstumsprozesse. Vorzugsweise kommt dabei die Niederdruck-Metallorganische Gasphasen-Epitaxie (MOCVD) und die Molekularstrahl-Epitaxie zum Einsatz. Mit beiden Methoden lassen sich einerseits dünnste Halbleiterschichten mit abrupten Übergängen abschieden, was eine wesentliche Voraussetzung für einen HEMT darstellt. Andererseits können Halbleiterschichten selektiv abgeschieden werden, was eine wesentliche Vorraussetzung für den erfindungsgemäßen Photoempfänger ist.

Da es sich bei den Halbleiter-Wachstumsprozessen um Hochtemperaturschritte handelt (500 bis 800 °C), bei denen Diffusionsprozesse auftreten, müssen die zur Bildung des HEMT notwendigen Halbleiterschichten möglichst kurzen Temperschritten (ca.100 Sek) unterliegen. Deshalb wird erst im zweiten Wachstumsprozeß die kritische HEMT-Struktur gewachsen. Die weniger empfindliche Wellenleiter-Struktur durchläuft dagegen zwei Wachstumsschritte.

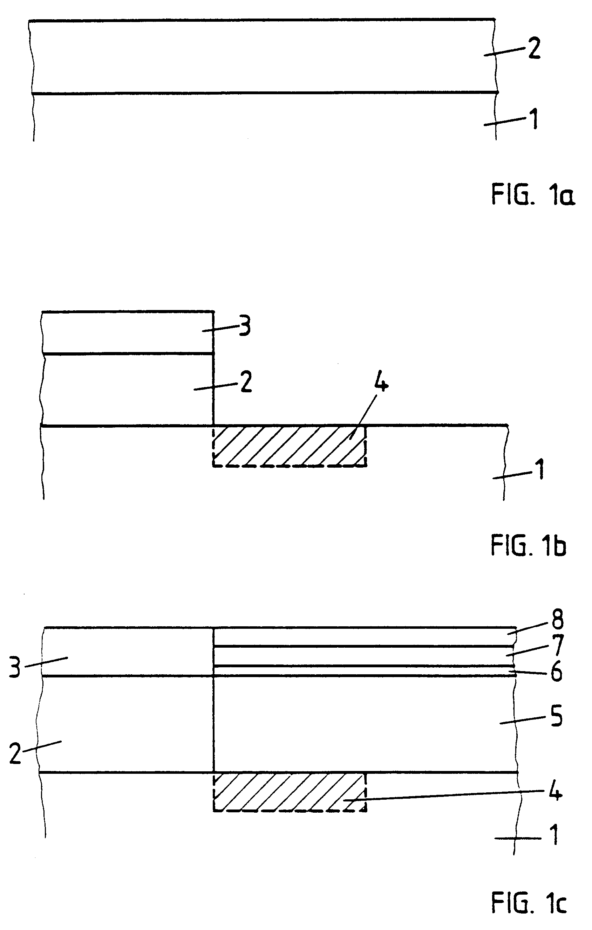

In den Fig. 1a bis 1c sind die einzelnen Verfahrensschritte aufgezeigt. Auf das Substrat 1 wird beispielsweise ganzflächig die lichtführende Halbleiterschicht 2 aufgebracht. Darauf ist eine Passivierungsschicht 3 abgeschieden, die ein weiteres Aufwachsen von Halbleiterschichten verhindert (Fig. 1b). Anschließend wird im Bereich der PIN-Photodiode und des HEMT das Substrat 1 freigelegt und beispielsweise eine n-dotierte Zone 4 für den n-Kontakt der PIN-Photodiode erzeugt (Fig. 1b). Danach wird selektiv die Heterostruktur für PIN-Photodiode und HEMT abgeschieden (Fig. 1c).

Um das Licht lediglich in der Halbleiterschicht 2 zu führen, besitzt das Substrat 1 und die Passivierungschicht 3 einen kleineren Brechungsindex als die lichtführende Halbleiterschicht 2. Eine geeignete Ankopplung des Wellenleiters an die PIN-Photodiode wird dadurch erzielt, daß in der lichtführenden Halbleiterschicht 2 das Licht seitlich begrenzt wird.
Diese seitliche Begrenzung erreicht man durch eine Änderung des Brechungsindex: der Brechungsindex muß in der lichtführenden Halbleiterschicht seitlich abnehmen. Der optische Wellenleiter kann deshalb unterschiedlich ausgebildet sein:
a) Die lichtführendeHalbleiterschicht is mesa-geätzt, so daß der Brechungsindex zum optisch dünneren Medium Luft abnimmt.
b) Auf die lichtführende Halbleiterschicht ist ein Oxidstreifen aufgebracht. An der Grenzfläche Oxidstreifen/ Halbleiterschicht wird dadurch eine mechanische Spannung erzeugt, die den Bandabstand der lichtführenden Halbleiterschicht im Bereich des Oxidstreifens verringert und damit den Brechungsindex vergrößert.
c) In die lichtführende Halbleiterschicht sind hochdotierte Zonen implantiert, die einen kleineren Brechungsindex besitzen als die lichtführende Halbleiterschicht.
d) Auf die lichtführende Halbleiterschicht ist ein metallischer Streifen aufgebracht, an den eine elektrische Spannung angelegt wird. Durch die elektrische Spannung wird im Bereich des metallischen Streifens der Bandabstand der Halbleiterschicht verringert und somit der Brechungsindex erhöht.

In den Ausführungsbeispielen sind verschiedene Alternativen für die Heterostruktur und die Bauformen des Photoempfängers angegeben.

In Ausführungsbeispiel 1 ist auf einem halbisolierenden Substrat 1, das z.B. aus InP besteht, zunächst ganzflächig eine n-dotierte, lichtführende Halbleiterschicht 2 aus InAlAs oder InAlAsP oder InGaAsP mit einer Ladungsträgerkonzentration von ungefähr 10¹⁵ bis 10¹⁷ cm⁻³ und einer Schichtdicke von etwa 1 µm aufgebracht. Die lichtführende Halbleiterschicht 2 ist in der vorher beschriebenen Weise strukturiert, so daß das Licht seitlich in der Halbleiterschicht 2 geführt wird. Eine Passivierungsschicht 3, z.B. aus SiO₂ oder Si₃N₄, wird auf die lichtführende Halbleiterschicht 2 abgeschieden. Sie dient als Schutzschicht für die nachfolgenden Ätzprozesse und verhindert das Abscheiden weiterer Halbleiterschichten im Bereich des Wellenleiters. Die Höhe der Passivierungsschicht ist so gewählt, daß Wellenleiter und PIN-Photodiode planar angeordnet sind.

In einem weiteren Arbeitsschritt wird das Substrat 1 im Bereich von PIN-Photodiode 18 und HEMT 19 freigelegt. In einem zweiten Wachstumsprozeß wird eine Heterostruktur aus
- einer n-dotierten Halbleiterschicht 5 aus InGaAs oder InGaAsP mit einer Ladungsträgerkonzentration von 10¹⁴ bis 10¹⁶ cm⁻³ und einer Schichtdicke von etwa 1 µm,
- einer undotierten Halbleiterschicht 6 aus InAlAs oder InP oder InGaAsP mit einer Schichtdicke von weniger als 20 nm,
- einer n-dotierten Halbleiterschicht 7 aus InAlAs oder InAlAsP oder InP mit einer Ladungsträgerkonzentration von 10¹⁷ bis 10¹⁸ cm⁻³ und einer Schichtdicke von 20 bis 100 nm,
- einer p-dotierten Halbleiterschicht 8 mit einer Ladungsträgerkonzentration von 10¹⁷ bis 10¹⁹ cm⁻³ und einer Schichtdicke von ungefähr 10 bis 500 nm aufgewachsen.

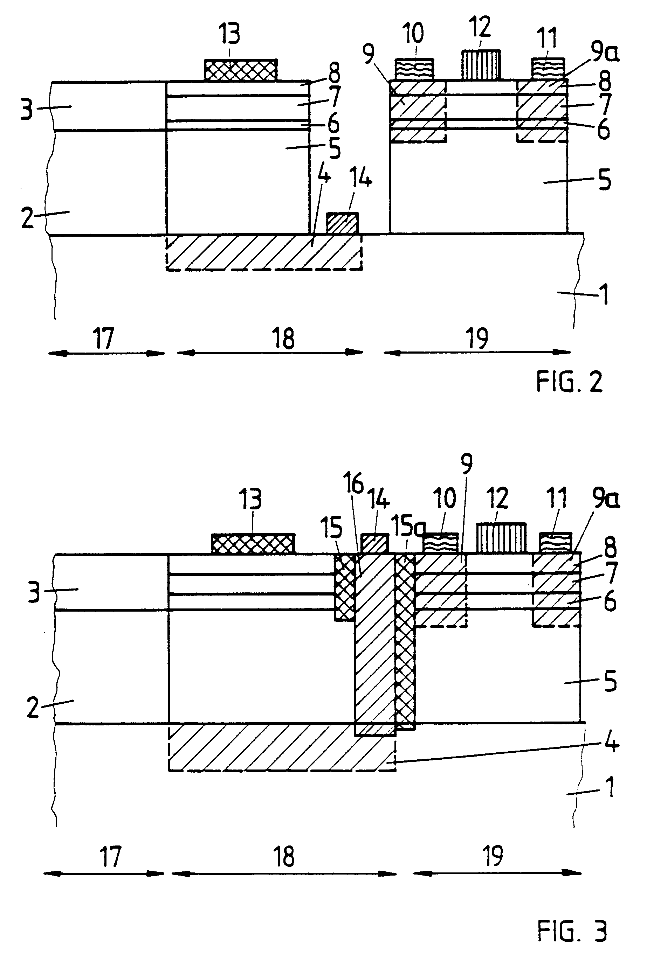

Gemäß Fig. 2 sind PIN-Photodiode 18 und HEMT 19 in Mesa-bauform angeordnet. Eine erste Elektrode 13 der PIN-Photodiode 18 ist auf die p-dotierte Halbleiterschicht 8 aufgebracht. Eine zweite Elektrode 14 der PIN-Photodiode 18 kontaktiert eine in das Substrat 1 implantierte n-dotierte Zone 4, die eine Ladungsträgerkonzentration von 10¹⁸ bis 10¹⁹ cm⁻³ und eine Tiefe von etwa 0,1 bis 0,5 µm besitzt. Die n-dotierte Zone 4 verringert den Zuleitungswiderstand der PIN-Photodiode 18.Die zweite Elektrode 14 ist beispielsweise rechteckig ausgebildet und umschließt die mesa-geätzte PIN-Photodiode 18.

Die n-dotierte Halbleiterschicht 5 wirkt in der PIN-Photodiode 18 als Absorptionsschicht für das eingestrahlte Licht. Der Brechungsindex der absorbierenden Halbleiterschicht 5 ist größer als der der lichtführenden Halbleiterschicht 2. Im HEMT 19 bildet sich in der n-dotierten Halbleiterschicht 5 ein Potentialtopf, in dem ein zweidimensionales Elektronengas eingeschlossen ist.

Source- und der Drain-Anschluß 10,11 des HEMT 19 sind auf n-implantierten Gebieten 9,9a angebracht, die senkrecht zu den Halbleiterschichten 5,6,7,8 verlaufen. Source- und Drain-Anschluß 10,11 sind sperrfreie metallische Kontakte, die über die n-leitenden Gebiete 9,9a mit dem zweidimensionalen Elektronengas, das sich an der Grenzfläche der n-dotierten Halbleiterschicht 5 und der undotierten Halbleiterschicht 6 befindet, verbunden sind. Der Gate-Anschluß 12 des HEMT 19 ist ein sperrfreier metallischer Kontakt, der auf die Halbleiterschicht 8 aufgebracht ist.

Im Ausführungsbeispiel 2 sind Photoempfänger und angekoppelter Wellenleiter aus der gleichen selektiv gewachsenen Heterostruktur aufgebaut wie im Ausführungsbeispiel 1.

In der planaren Anordnung von PIN-Photodiode 18 und HEMT 19 (Fig. 3) ist die zweite Elektrode 14 der PIN-Photodiode 18 über ein n-leitendes Gebiet 16 mit der n-dotierten Zone 4 verbunden. Außerdem werden durch Implantation, z.B. mit Fe, oder durch geeignete Ätzverfahren und nachfolgenden Auffülltechniken, z.B. mit Polyimid, Isolationsgebiete 15, 15a erzeugt.

Ein erstes Isolationsgebiet 15 trennt die Elektroden 13, 14 der PIN-Photodiode 18.

Ein zweites Isolationsgebiet 15a ist zwischen PIN-Photodiode 18 und HEMT 19 eingebracht.

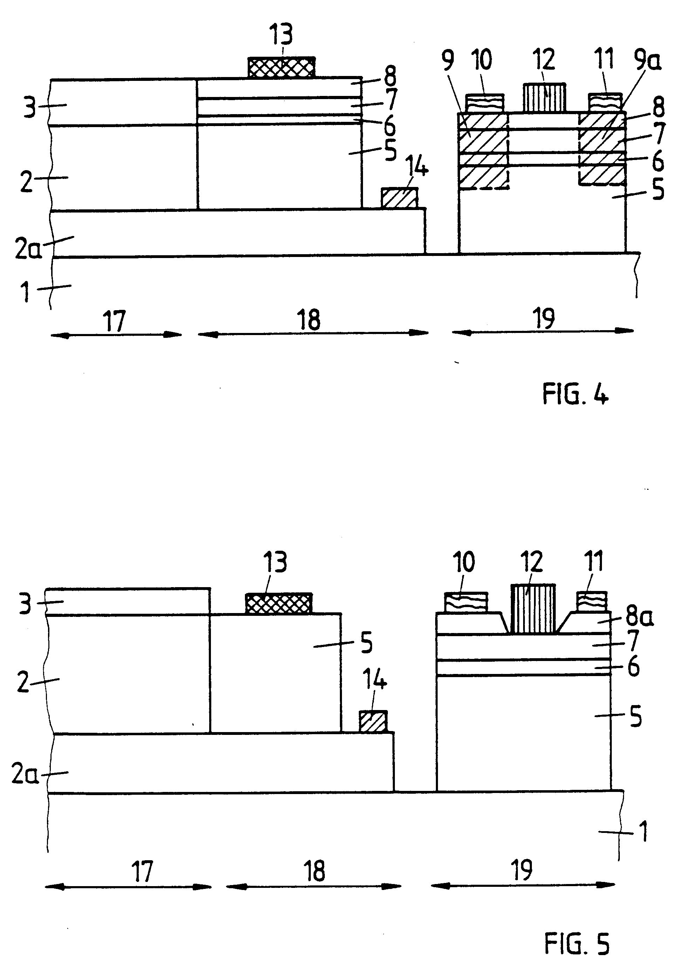

Im Ausführungsbeispiel 3 ist auf das halbisolierende InP-Substrat 1 im Bereich des Wellenleiters 17 und der PIN-Photodiode 18 eine n-dotierte Zwischenschicht 2a mit einer Ladungsträgerkonzentration von 10¹⁷ bis 5 10¹⁸ cm⁻³ und einer Schichtdicke von etwa 0,2 bis 2 µm aufgewachsen (Fig. 4). Beispielhafte Halbleitermaterialien der Zwischenschicht 2a sind InAlAs oder InAlAsP oder InGaAsP oder InP. Im Bereich des HEMT 19 ist das Substrat 1 durch geeignete Ätztechniken freigelegt. Die auf die Zwischenschicht 2a und das Substrat 1 aufgebrachte Heterostruktur und die Bauform des erfindungsgemäßen Photoempfängers sind analog den Ausführungsbeispielen 1 oder 2 gewählt.

Der zweischichtige Wellenleiter gemäß Ausführungsbeispiel 3 besteht aus der lichtführenden Halbleiterschicht 2 und der Zwischenschicht 2a. Die lichtführende Halbleiterschicht 2 besitzt einen größeren Brechungsindex als die Zwischenschicht 2a. Dadurch wirkt die Zwischenschicht 2a als optische Confinement-Schicht. Außerdem besitzt die Zwischenschicht 2a eine hohe Dotierung und ist als gutleitende Kontaktschicht für die selektiv eingebrachte, absorbierende Halbleiterschicht 5 der PIN-Photodiode ausgebildet. Die zweite Elektrode 14 der PIN-Photodiode 18 kontaktiert die Zwischenschicht 2a. Das Einbringen einer hochdotierten Zone 4 in das Substrat 1 ist deshalb nicht mehr notwendig. Weiterhin wirkt die Zwischenschicht 2a als Pufferschicht und begrenzt Kristalldefekte auf die Grenzfläche Substrat/Zwischenschicht.

Infolge der nur teilweise vorhandenen Zwischenschicht 2a beim selektiven Wachstumsprozeß der Halbleiterschichten 5 bis 8 und wegen des örtlich gleichen Wachstums liegt die Oberfläche des HEMT 19 tiefer als die der PIN-Photodiode 18 (Fig. 4). Da die Dicke der Zwischenschicht 2a jedoch weniger als 2 µm beträgt, wirkt sich die Stufe zwischen PIN-Photodiode und HEMT nicht störend auf die Prozeßtechnik aus.

In den Ausführungsbeispielen 1 bis 3 erfolgt die Steuerung von PIN-Photodiode 18 und HEMT 19 durch einen p/n-Übergang, der von der p-dotierten Halbleiterschicht 8 und der n-dotierten Halbleiterschicht 7 erzeugt ist.

Im Ausführungsbeispiel 4 ist auf einem halbisolierenden InP-Substrat 1 eine p-dotierte Zwischenschicht 2a aus InAlAs oder InAlAsP oder InGaAsP mit einer Ladungsträgerkonzentration von 10¹⁷ bis 10¹⁹ cm⁻³ und einer Schichtdicke von 0,2 bis 2 µm aufgewachsen. Die folgenden Halbleiterschichten 2 bis 7 sind analog Ausführungsbeispiel 1 gewählt. Lediglich die oberste Halbleiterschicht 8a der Heterostruktur ist n-dotiert und besitzt eine Ladungsträgerkonzentration von 10¹⁷ bis 10¹⁹ cm⁻³ und eine Schichtdicke von 10 bis 500 nm. Geeignete Halbleitermaterialien sind beispielsweise InAlAs oder InP oder InGaAsP. Auf die n-dotierte Halbleiterschicht 8a sind Source- und Drain-Anschluß 10,11 des HEMT 19 aufgebracht. Im Bereich des Gate-Anschlusses 12 des HEMT 19 ist die n-dotierte Halbleiterschicht 8 entfernt und der sperrende metallische Kontakt ist auf die n-dotierte Halbleiterschicht 7 aufgebracht.

Im Bereich der PIN-Photodiode 18 sind die oberen Halbleiterschichten 6 bis 8 entfernt und die erste Elektrode 13 kontaktiert die absorbierende, n-dotierte Halbleiterschicht 5. Die zweite Elektrode 14 befindet sich auf der p-leitenden Zwischenschicht 2b. Die p-leitende Zwischenschicht 2b und die absorbierende, n-dotierte Halbleiterschicht 5 bilden den steuernden p/n-Übergang der PIN-Photodiode. Fig. 5 zeigt eine Mesabauform von PIN-Photodiode 18 und HEMT 19 mit p-leitendem Wellenleiter 17 mit einer Heterostruktur laut Ausführungsbeispiel 4.

Die in den Ausführungsbeispielen beschriebenen Anordnungen von PIN-Photodioden und HEMT sind nicht auf die angegebene Bauform beschränkt, sondern es sind sowohl Mesabauform als auch planare Bauform möglich.

Die Isolierung von PIN-Photodiode 18 und HEMT 19 in einer planaren Anordnung wird durch ionen-implantierte (z.B. mit Fe) oder geätzte und anschließend mit z.B. Polyimid aufgefüllte Gebiete 15, 15a analog Fig. 3 erreicht.

In allen Ausführungsbeispielen sind die Elektroden 13, 14 der PIN-Photodiode 18 und die elektrischen Anschlüsse 10,11, 12 des HEMT 19 metallische Kontakte aus z.B. einer Au/Ge- oder Au/Zn-Legierung. Die elektrischen Kontakte der einzelnen Bauelemente des Photoempfängers können beispielsweise über metallische Leiterbahnen in geeigneter Weise miteinander verknüpft werden.

Die Oberfläche des Photoempfängers ist vorteilhafterweise mit einer Oxidschicht überzogen, die als Passivierungsschicht und/oder als Implantationsfenster sowie für die Kontaktstrukturierung geeignet ist.

Für die p-Dotierung verwendete Materialien sind beispielsweise Be, Mg oder Zn und für die n-Dotierung Si, S oder Sn.

Zur Verbesserung der Sperreigenschaften des Gate-Anschlusses 12 des HEMT 19 variiert die Dotierung der n -leitenden Halbleiterschicht 7 in vertikaler Richtung, so daß die Dotierkonzentration zur darauffolgenden Halbleiterschicht 8 bzw. 8a auf Null abnimmt.

Die Erfindung ist nicht auf die beschriebenen Ausführungsbeispiele beschränkt, sondern es kann zum Beispiel das Substrat 1 aus n- oder p-leitendem InP oder Si bestehen, auf dem eine Pufferschicht aufgebracht ist. Weiterhin können die Pfufferschicht und die Halbleiterschichten 6, 7, der in den Ausführungsbeispielen beschriebenen Heterostrukturen, als Übergitter aufgebaut sein. Geeignete Materialien zur Bildung eines entsprechenden Übergitters sind z.B. InAs/InP oder GaAs/InGaAsP oder GaP/InGaAsP. In einer weiteren Ausführungsform kann die Schichtdicke der lichtführenden Halbleiterschicht 2 des Wellenleiters 17 kleiner gewählt werden als die der absorbierenden Halbleiterschicht 5 der PIN-Photodiode 18. Damit wird eine Anpassung des eingeführten Lichtes an die jeweilige Ausbreitung der Raumladungszone in der absorbierenden Halbleiterschicht 5 der PIN-Photodiode 18 erreicht.

## Patentansprüche

1. Verfahren zur Herstellung eines monolithisch integrierten Photoempfängers, bestehend aus mindestens einer PIN-Photodiode mit einer absorbierenden Halbleiterschicht und zumindest einem zugehörigen Verstärker, und bei dem ein optischer Wellenleiter mit einer lichtführenden Schicht seitlich an die PIN-Photodiode herangeführt ist,
dadurch gekennzeichnet,
- daß auf einem Halbleiterkörper,
der aus einem Substrat (1) und einer auf dem Substrat aufgewachsenen ersten Halbleiter-Heterostruktur (2) besteht, welche die lichtführende Schicht (2) des optischen Wellenleiters (17) bildet, wobei das Substrat teilweise freigelegt wird,
eine zweite Halbleiter-Heterostruktur (5,6,7,8,8a) selektiv auf dem freigelegten Teil des Substrats (1) epitaktisch aufgewachsen wird, aus welcher die PIN-Photodiode (18) sowie der Verstärker (19) hergestellt werden, welche die absorbierende Halbleiterschicht (5) der PIN-Photodiode (18) enthält und welche aus Halbleiterschichten besteht, die von denen der ersten Heterostruktur verschieden sind,
- daß das Substrat (1) aus einem Material mit einem kleineren Brechungsindex als dem der lichtführenden Halbleiterschicht (2) besteht, und
- daß die lichtführende Halbleiterschicht (2) des Wellenleiters (17) aus einem Halbleitermaterial mit einem kleineren Brechungsindex als dem der absorbierenden Halbleiterschicht (5) der PIN-Photodiode (18) besteht,
wobei
- der optische Wellenleiter durch monolitische Integration an die PIN-Photodiode angekoppelt ist,
- die lichtführende Halbleiterschicht (2) des Wellenleiters (17) seitlich an die absorbierende Halbleiterschicht (5) der PIN-Photodiode (18) angekoppelt ist und folglich das parallel zur Halbleiterschicht (2) geführte Licht des Wellenleiters (17) direkt in die absorbierende Halbleiterschicht (5) der PIN-Photodiode (18) eingestrahlt wird.

2. Verfahren nach Anspruch 1, dadurch gekennzeichnet, daß im Bereich der PIN-Photodiode (18) im Substrat (1) eine n-dotierte Zone (4) mit einer Ladungsträgerkonzentration von 10¹⁸ bis 10¹⁹ cm⁻³ erzeugt wird.

3. Verfahren zur Herstellung eines monolithisch integrierten Photoempfängers, bestehend aus mindestens einer PIN-Photodiode mit einer absorbierenden Halbleiterschicht und zumindest einem zugehörigen Verstärker, und bei dem ein optischer Wellenleiter mit einer lichtführenden Schicht seitlich an die PIN-Photodiode herangeführt ist,
dadurch gekennzeichnet,
- daß auf einem Halbleiterkörper,
der aus einem Substrat (1), einer auf einem Teil des Substrats vorhandenen Zwischenschicht (2a), und einer auf der Zwischenschicht aufgewachsenen ersten Halbleiter-Heterostruktur (2) besteht, welche die lichtführende Schicht (2) des optischen Wellenleiters (17) bildet, wobei das Substrat und die Zwischenschicht (2a) teilweise freigelegt werden,
eine zweite Halbleiter-Heterostruktur (5,6,7,8,8a) selektiv auf den freigelegten Teilen des Substrats (1) und der Zwischenschicht (2a) epitaktisch aufgewachsen wird, aus welcher die PIN-Photodiode (18) im Bereich der Zwischenschicht (2a) sowie der Verstärker (19) im Bereich des Substrats (1) hergestellt werden, welche die absorbierende Halbleiterschicht (5) der PIN-Photodiode (18) enthält und welche aus Halbleiterschichten besteht, die von denen der ersten Heterostruktur verschieden sind,
- daß die Zwischenschicht (2a) aus einem Material mit einem kleineren Brechungsindex als dem der lichtführenden Halbleiterschicht (2) besteht, und
- daß die lichtführende Halbleiterschicht (2) des Wellenleiters (17) aus einem Halbleitermaterial mit einem kleineren Brechungsindex als dem der absorbierenden Halbleiterschicht (5) der PIN-Photodiode (18) besteht,
wobei
- der optische Wellenleiter durch monolitische Integration an die PIN-Photodiode angekoppelt ist,
- die lichtführende Halbleiterschicht (2) des Wellenleiters (17) seitlich an die absorbierende Halbleiterschicht (5) der PIN-Photodiode (18) angekoppelt ist und folglich das parallel zur Halbleiterschicht (2) geführte Licht des Wellenleiters (17) direkt in die absorbierende Halbleiterschicht (5) der PIN-Photodiode (18) eingestrahlt wird.

4. Verfahren nach einem der Ansprüche 2 oder 3, dadurch gekennzeichnet,
- daß die erste Heterostruktur aus einer n-dotierten, lichtführenden Halbleiterschicht (2) mit einer Ladungsträgerkonzentration von ungefähr 10¹⁵ bis 10¹⁷ cm⁻³ besteht,
- daß eine Passivierungsschicht (3) darauf aufgebracht wird, wobei der Wellenleiter (17) zumindest aus diesen beiden Schichten (2,3) gebildet ist, und
- daß die zweite Heterostruktur aus einer n-dotierten Halbleiterschicht (5) mit einer Ladungsträgerkonzentration von 10¹⁴ bis 10¹⁶ cm⁻³, einer undotierten Halbleiterschicht (6), einer n-dotierten Halbleiterschicht (7) mit einer Ladungsträgerkonzentration von 10¹⁷ bis 10¹⁸ cm⁻³ und einer p- oder n-dotierten Halbleiterschicht (8, 8a) mit einer Ladungsträgerkonzentration von 10¹⁷ bis 10¹⁹ cm⁻³ besteht, aus der die PIN-Photodiode (18) und der zugehörige Verstärker hergestellt werden.

5. Verfahren nach einem der vorhergehenden Ansprüchen, dadurch gekennzeichnet,
daß der zur PIN-Photodiode (18) zugehörige Verstärker (19) als HEMT hergestellt wird.

6. Verfahren nach Anspruch 5, dadurch gekennzeichnet, daß die Halbleitermaterialien der Heterostrukturen so gewählt sind, daß die Wellenlängen λ des Wellenlängenbereichs des Photoempfängers die Bedingung 0,8 µm ≦ λ ≦ 1,55 µm erfüllen.

## Claims

1. Method of manufacturing a monolithically integrated photodetector consisting of at least one PIN photodiode with an absorbing semiconductor layer and at least one associated amplifier and in which an optical waveguide is led by a light-conducting layer laterally to the PIN photodiode, characterised thereby,
- that on a semiconductor body,
which consists of a substrate (1) and a first semiconductor heterostructure (2), which is grown onto the substrate and forms the light-conducting layer (2) of the optical waveguide (17), wherein the substrate is partially exposed,
a second semiconductor heterostructure (5, 6, 7, 8, 8a) is epitaxially grown selectively on the exposed part of the substrate (1), out of which the PIN photodiode (18) as well as the amplifier (19) are made and which contains the absorbing semiconductor layer (5) of the PIN photodiode (18) and consists of semiconductor layers differing from those of the first heterostructure,
- that the substrate (1) consists of a material of a lower refractive index than that of the light-conducting semiconductor layer (2) and
- that the light-conducting semiconductor layer (2) of the waveguide (17) consists of a semiconductor material of a lower refractive index than that of the absorbing semiconductor layer (5) of the PIN photodiode (18), wherein
- the optical waveguide is coupled to the PIN photodiode by monolithic integration and
- the light-conducting semiconductor layer (2) of the waveguide (17) is coupled laterally to the absorbing semiconductor layer (5) of the PIN photodiode (18) and the light, which is guided parallelly to the semiconductor layer (2), of the waveguide (17) is consequently radiated directly into the absorbing semiconductor layer (5) of the PIN photodiode (18).

2. Method according to claim 1, characterised thereby, that an n-doped zone (4) with a charge carrier concentration of 10¹⁸ to 10¹⁹ per cubic centimetre is produced in the substrate (1) in the region of the PIN photodiode (18).

3. Method of manufacturing a monolithically integrated photodetector consisting of at least one PIN photodiode with an absorbing semiconductor layer and at least one associated amplifier and in which an optical waveguide is led by a light-conducting layer laterally to the PIN photodiode, characterised thereby,
- that on a semiconductor body,
which consists of a substrate (1), an intermediate layer (2a) present on a part of the substrate and a first semiconductor heterostructure (2), which is grown onto the intermediate layer and forms the light-conducting layer (2) of the optical waveguide (17), wherein the substrate and the intermediate layer (2a) are partially exposed,
a second semiconductor heterostructure (5, 6, 7, 8, 8a) is epitaxially grown selectively on the exposed parts of the substrate (1) and the intermediate layer (2a), out of which the PIN photodiode (18) is made in the region of the intermediate layer (2a) as well as the amplifier (19) is made in the region of the substrate (1), which contains the absorbing semiconductor layer (5) of the PIN photodiode (18) and consists of semiconductor layers differing from those of the first heterostructure,
- that the intermediate layer (2a) consists of a material of a lower refractive index than that of the light-conducting semiconductor layer (2) and
- that the light-conducting semiconductor layer (2) of the waveguide (17) consists of a semiconductor material of a lower refractive index than that of the absorbing semiconductor layer (5) of the PIN photodiode (18), wherein
- the optical waveguide is coupled to the PIN diode by monolithic integration and
- the light-conducting semiconductor layer (2) of the waveguide (17) is coupled laterally to the absorbing semiconductor layer (5) of the PIN photodiode (18) and the light, which is guided parallelly to the semiconductor layer (2), of the waveguide (17) is consequently radiated directly into the absorbing semiconductor layer (5) of the PIN photodiode (18).

4. Method according to one of the claims 2 and 3, characterised thereby,
- that the first heterostructure consists of an n-doped, light-conducting semiconductor layer (2) with a charge carrier concentration of approximately 10¹⁵ to 10¹⁷ per cubic centimetre,
- that a passivation layer (3) is applied onto that, wherein the waveguide (17) is formed of at least both these layers (2, 3) and
- that the second heterostructure consists of an n-doped semiconductor layer (5) with a charge carrier concentration of 10¹⁴ to 10¹⁶ per cubic centimetre, an undoped semiconductor layer (6), an n-doped semiconductor layer (7) with a charge carrier concentration of 10¹⁷ to 10¹⁸ per cubic centimetre and a p-doped or n-doped semiconductor layer (8, 8a) with a charge carrier concentration of 10¹⁷ to 10¹⁸ per cubic centimetre, out of which the PIN photodiode (18) and the associated amplifier are made.

5. Method according to one of the preceding claims, characterised thereby, that the amplifier (19) belonging to the PIN photodiode (18) is made as high electron mobility transistor.

6. Method according to claim 5, characterised thereby, that semiconductor materials of the heterostructures are so chosen that the wavelength λ of the wavelength range of the photodetector fulfil the condition of being equal to or greater than 0.8 micrometres and equal to or less than 1.55 micrometres.

## Revendications

1. Procédé pour fabriquer un photodétecteur intégré monolithique, constitué d'au moins une photodiode PIN comportant une couche de semi-conducteur absorbante, ainsi que d'au moins un amplificateur associé, et dans lequel un guide d'onde optique, comportant une couche conductrice de lumière, est amené latéralement à la photodiode PIN, caractérisé en ce que
- sur un corps semi-conducteur composé d'un substrat (1) et d'une première hétérostructure de semi-conducteurs (2) que l'on a fait croître sur le substrat et qui forme la couche conductrice de lumière (2) du guide d'onde optique (17), on dégage ou dénude partiellement le substrat et on fait croître sélectivement sur la partie dégagée du substrat (1), par épitaxie, une deuxième hétérostructure de semi-conducteurs (5, 6, 7, 8, 8a), à partir de laquelle sont fabriqués la photodiode PIN (18) ainsi que l'amplificateur (19), deuxième hétérostructure qui contient la couche de semi-conducteur (5) absorbante de la photodiode PIN (18) et qui est composée de couches de semi-conducteur qui diffèrent de celles de la première hétérostructure,
- le substrat (1) est fait d'un matériau ayant un plus petit indice de réfraction que la couche de semi-conducteur conductrice de lumière (2) et
- la couche de semi-conducteur conductrice de lumière (2) du guide d'onde (17) est faite d'un matériau semiconducteur ayant un plus petit indice de réfraction que la couche de semi-conducteur absorbante (5) de la photodiode PIN (18),
- le guide d'onde optique étant accouplé à la photodiode PIN par intégration monolithique et
- la couche de semi-conducteur conductrice de lumière (2) du guide d'onde (17) étant couplée latéralement à la couche de semi-conducteur absorbante (5) de la photodiode PIN (18), de sorte que la lumière du guide d'onde (17), guidée parallèlement à la couche de semi-conducteur conductrice de lumière (2), est rayonnée directement dans la couche de semi-conducteur absorbante (5) de la photodiode PIN (18).

2. Procédé selon la revendication 1, caractérisé en ce que l'on crée à l'intérieur du substrat (1), dans la zone de la photodiode PIN (18), une zone (4),dopée n, ayant une concentration de porteurs de charge de 10¹⁸ à 10¹⁹ cm⁻³.

3. Procédé pour fabriquer un photodétecteur intégré monolithique, constitué d'au moins une photodiode PIN comportant une couche de semi-conducteur absorbante, ainsi que d'au moins un amplificateur associé, et dans lequel un guide d'onde optique comportant une couche conductrice de lumière est amené latéralement à la photodiode PIN, caractérisé en ce que
- sur un corps semi-conducteur composé d'un substrat (1), d'une couche intermédiaire (2a) présente sur une partie du substrat et d'une première hétérostructure de semi-conducteurs (2) que l'on a fait croître sur la couche intermédiaire et qui constitue la couche conductrice de lumière (2) du guide d'onde optique (17), on dégage ou dénude partiellement le substrat et la couche intermédiaire (2a) et on fait croître sélectivement, sur les parties dégagées du substrat (1) et de la couche intermédiaire (2a), par épitaxie, une deuxième hétérostructure de semi-conducteurs (5, 6, 7, 8, 8a), à partir de laquelle sont fabriqués la photodiode PIN (18), dans la zone de la couche intermédiaire (2a), ainsi que l'amplificateur (19), dans la zone du substrat (1), deuxième hétérostructure qui contient la couche de semi-conducteur absorbante (5) de la photodiode PIN (18) et est composée de couches de semi-conducteur qui diffèrent de celles de la première hétérostructure,
- la couche intermédiaire (2a) est faite d'un matériau dont l'indice de réfraction est plus petit que celui de la couche de semi-conducteur conductrice de lumière (2) et
- la couche de semi-conducteur conductrice de lumière (2) du guide d'onde (17) est faite d'un matériau semiconducteur ayant un plus petit indice de réfraction que la couche de semi-conducteur absorbante (5) de la photodiode PIN (18),
- le guide d'onde optique étant couplé à la photodiode PIN par intégration monolithique et
- la couche de semi-conducteur conductrice de lumière (2) du guide d'onde (17) étant couplée latéralement à la couche de semi-conducteur absorbante (5) de la photodiode PIN (18), de sorte que la lumière du guide d'onde (17), guidée parallèlement à la couche de semi-conducteur conductrice de lumière (2), est rayonnée directement dans la couche de semi-conducteur absorbante (5) de la photodiode PIN (18).

4. Procédé selon la revendication 2 ou 3, caractérisé en ce que
- la première hétérostructure comprend une couche de semi-conducteur conductrice de lumière (2) dopée n, ayant une concentration de porteurs de charge d'environ 10¹⁵ à 10¹⁷ cm⁻³,
- on applique sur cette couche de semi-conducteur (2) une couche de passivation (3), le guide d'onde (17) étant formé au moins de ces deux couches (2, 3) et
- la deuxième hétérostructure est composée d'une couche de semi-conducteur (5) dopée n, ayant une concentration de porteurs de charge de 10¹⁴ à 10¹⁶ cm⁻³, d'une couche de semi-conducteur (6) non dopée, d'une couche de semiconducteur (7) dopée n et ayant une concentration de porteurs de charge de 10¹⁷ à 10¹⁸ cm⁻³ et d'une couche de semi-conducteur (8, 8a), dopée p ou n et ayant une concentration de porteurs de charge de 10¹⁷ à 10¹⁹ cm⁻³, à partir desquelles sont fabriqués la photodiode PIN (18) et l'amplificateur associé.

5. Procédé selon une des revendications précédentes, caractérisé en ce que l'amplificateur (19) associé à la photodiode PIN (18) est formé par un transistor à mobilité électronique (des électrons) élevée (HEMT).

6. Procédé selon la revendication 5, caractérisé en ce que les matériaux semi-conducteurs des hétérostructures sont choisis de manière que les longueurs d'onde λ de la gamme de longueurs d'onde du photodétecteur remplissent la condition 0,8 µm ≦ λ ≦ 1,5 µm.
